# EUROPÄISCHE PATENTANMELDUNG

(11) **EP 1 107 010 A2**
(43) Veröffentlichungstag der Anmeldung: **13.06.2001**
(21) Anmeldenummer: 00124681.8
(22) Anmeldetag: 11.11.2000
(51) Int. Cl.: G01R 29/16

(54) **Phasenausfall-Überwachung**

(30) Priorität: 03.12.1999 DE 19958369
(71) Anmelder: Siemens Metering AG, 6300 Zug (CH)
(72) Erfinder: Wasmer, Roland, 6048 Horw (CH)

(57) **Zusammenfassung**

Um bei einem elektronischen Gerät (1a), insbesondere einem Elektrizitätszähler (1b), eine einfache Möglichkeit der Überwachung des Ausfalls der Referenzphase (L2) zu realisieren, ist vorgesehen, dass der Winkel (a) zwischen zwei erfassten verketteten Spannungen (UL2/L3 und UL2/L1) gemessen wird. Beim Überschreiten eines vorgebbaren Grenzwertes (aG) für den Winkel (a) wird Fehlersignal erzeugt, das den Ausfall der Bezugs- oder Referenzphase (L2) repräsentiert. Bevorzugt findet eine Anwendung der Idee im Zusammenhang mit der Aronschaltung statt.

## Beschreibung

Die Erfindung betrifft ein Verfahren für eine Phasenausfall-Überwachung und ein elektrisches Gerät, insbesondere einen Elektrizitätszähler, mit einer Phasenausfall-Überwachung.

Bei einem Elektrizitätszähler ist es allgemein bekannt, die sogenannte Aronschaltung zur Ermittlung des Energieverbrauchs über alle Phasen zu verwenden. Diese Schaltung dient dazu, die Anzahl benötigter Strom- und Spannungswandler zu reduzieren. Dabei werden statt der drei Phasenspannungen eines Dreiphasen-Drehstromnetzes lediglich zwei verkettete Spannungen und zwei Ströme erfasst. Gegebenenfalls kann optional durch vektorielle Addition oder Summation der beiden verketteten Spannungen die Spannung der dritten Phase erzeugt oder nachgebildet werden.

Fällt im Betrieb die gemeinsame Phase (auch Bezugsphase genannt) der beiden verketteten Spannungen einmal aus, so wird das Messergebnis wegen des Fehlens des Referenzpotentials verfälscht. Aus der Praxis ist es hierzu bekannt, die fehlende Referenzphase durch eine einfache Messung der Spannungsamplitude zu ermitteln. Fehlt nämlich die Referenzphase, so verringern sich die Werte der verketteten Spannungen symmetrisch auf kleinere Werte. Im Hinblick auf heutige moderne "Wide Voltage Range" Netzteile und/oder -geräte ist eine Auslegung der Spannungsüberwachung auf mehrere Grenzen erforderlich, wodurch diese Überwachungsmethode zu unsicher ist.

Der Erfindung liegt die Aufgabe zugrunde, eine einfache Möglichkeit für die Überwachung des Ausfalls der Referenzphase in einem Dreileitersystem anzugeben.

Die Lösung der Aufgabe gelingt erfindungsgemäss mit den Merkmalen der Ansprüche 1 und 6.

Dabei sind zur Phasenausfall-Überwachung in einem elektronischen Gerät, insbesondere einem Elektrizitätszähler, für Drehspannung folgende Verfahrensschritte vorgesehen:
- Es werden zwei verkettete Spannungen eines Dreiphasen-Drehstromnetzes erfasst,
- es wird der Phasenwinkel zwischen den zwei erfassten verketteten Spannungen ermittelt und mit einem vorgegebenen Grenzwinkel verglichen,
- im Falle einer Überschreitung des vorgegebenen Grenzwinkels durch den ermittelten Phasenwinkel wird ein Fehlersignal für den Ausfall der gemeinsamen Bezugsspannung zwischen den zwei erfassten Spannungen erzeugt.

Somit ist die Phasenausfall-Überwachung auf einfache Weise durch eine Winkelmessung realisiert. Gegebenenfalls kann für die Winkelmessung ein bereits im Elektrizitätszähler vorhandenes Winkelmessglied verwendet werden. Bei einer digitalen Ausführung wird auch Speicherplatz gespart. Dabei werden die zwei erfassten verketteten Spannungen vor der weiteren Verarbeitung digitalisiert.

Mit Vorteil kann mittels Addition oder Summation der zwei erfassten verketteten Spannungen die dritte verkettete Spannung nachgebildet werden. Somit steht auch diese Grösse für eine Verarbeitung zur Verfügung.

In einer bevorzugten Ausführungsform sind die drei Phasen des Drehstromnetzes mit einer Aronschaltung verbunden, mittels derer der Energieverbrauch einer an das Drehstromnetz angeschlossenen Last ermittelt wird. Die Aronschaltung kann dabei durch entsprechende Messwerke als Hardware oder auch bei einer digitalen Verarbeitung als Rechenschritt in einem Programm nachgebildet sein. Eine einfache Hardwarelösung ist bei der Verwendung von Hallelementen im Eingangsteil eines Elektrizitätszählers gegeben. Das Verfahren der Phasenausfall-Überwachung ist allgemein bei elektrischen oder elektronischen Geräten einsetzbar.

Bevorzugt ist das elektronische Gerät als Elektrizitätszähler ausgebildet, wobei alle verketteten Spannungen zur Ermittlung eines Energieverbrauchs einer Last am Drehstromnetz verwendet werden. Das Gerät weist erfindungsgemäss folgende Komponenten auf:
- Zwei Spannungssensoren zur Erfassung von zwei verketteten Spannungen eines Dreiphasen-Drehstromnetzes,
- einem Winkelmesser mit einem Grenzwertglied und einem Meldeglied,
wobei dem Winkelmesser die zwei verketteten Spannungen zugeführt sind und im Falle einer Überschreitung eines vorgegebenen Grenzwertes durch den gemessenen Phasenwinkel zwischen den erfassten verketteten Spannungen mit dem Meldeglied ein Signal für den Ausfall der gemeinsamen Bezugsspannung zwischen den zwei erfassten Spannungen erzeugbar ist.

Ausführungsbeispiele der Erfindung, weitere Vorteile und Details werden nachfolgend anhand der Zeichnung näher erläutert. Es zeigen:
Figur 1 ein Blockschaltbild eines erfindungsgemässen elektronischen Geräts,
Figur 2 ein weiteres Blockschaltbild eines digitalen Geräts und
Figur 3 ein Spannungszeigerdiagramm.

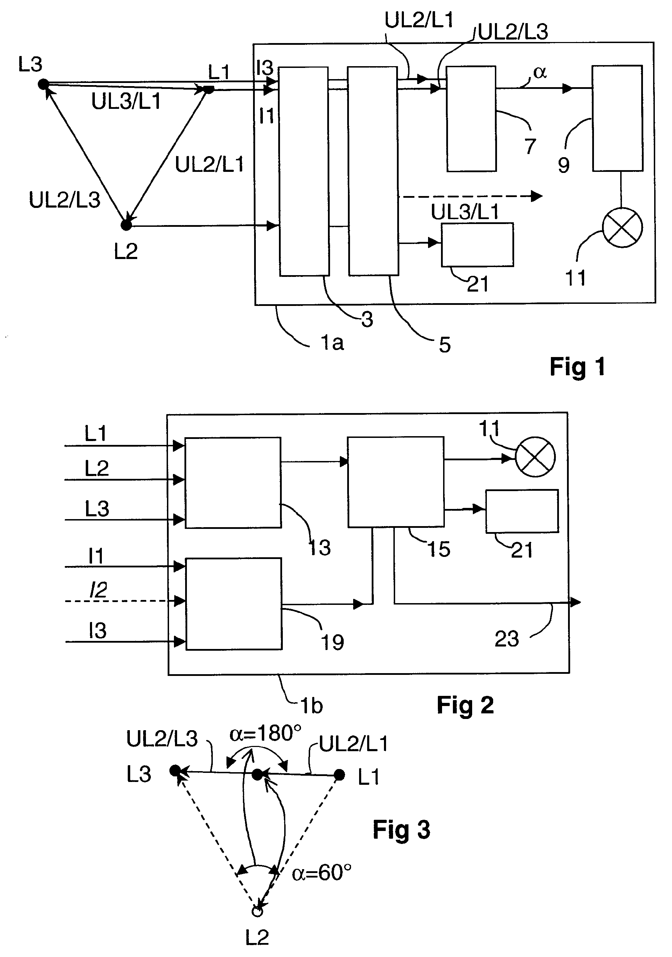

Figur 1 zeigt eine elektrische Darstellung eines Dreileiter-Drehstromnetzes mit den Phasen L1, L2 und L3. Zur Erfassung der jeweiligen Phasenspannungen oder drei verketteten Spannungen werden im Normalfall drei Spannungswandler oder Spannungssensoren verwendet. Bei der sogenannten Aronschaltung werden lediglich zwei verkettete Spannungen und zwei Ströme erfasst. Bei Bedarf kann die dritte Spannung durch geometrische oder vektorielle Summation oder Subtraktion errechnet, ermittelt oder nachgebildet werden.

Vorliegend werden beispielsweise die beiden verketteten Spannungen UL2/L3 und UL2/L1 einem Messmodul 3 eines elektronischen Geräts 1a, das bevorzugt als elektronischer Elektrizitätszähler ausgebildet ist, zugeführt. Das Messmodul 3 beinhaltet übliche Spannungserfassungmittel, z.B. Spannungsteiler oder auch Spannungswandler. Die erfassten verketteten Spannungen UL2/L3 und UL2/L 1 werden einem Verknüpfungsmodul 5 zugeführt, das Mittel zur Nachbildung der Aronschaltung umfasst. Diese Mittel können zum Beispiel zwei Messwerke zur Ermittlung des Energieverbrauchs einer an das Drehstromnetz angeschlossenen Last sein, wobei den Messwerken jeweils ein Phasenstom und eine verkettete Spannung zugeführt sind. Die Messwerke oder das Verknüpfungsmodul 5 können auch Anzeigemittel für den Energieverbrauch umfassen. Vorliegend ist hierzu ein Anzeigemodul 21 an das Verknüpfungsmodul 5 angeschlossen, das z.B. als LCD-Display ausgebildet sein kann.

Gegebenenfalls kann in dem Verknüpfungsmodul 5 bei Bedarf auch die dritte verkettete Spannung UL3/L1 nachgebildet werden. Ausgehend von den in der Figur 1 eingezeichneten Spannungsrichtungspfeilen ergibt sich die dritte verkettete Spannung UL3/L1 zwischen L3 und L1 aus einer Addition von -UL2/L3 und -UL2/L1. Somit stehen dann alle verketteten Spannungen des Drehstromnetzes zur Verfügung und können für eine weitere Bearbeitung im elektronischen Gerät 1 verwendet werden. Auf eine beispielhafte Verwendung wird nachfolgend bei der Beschreibung der Figur 2 noch näher eingegangen.

Wesentlich für die korrekte Funktion des elektronischen Gerätes 1 ist, dass auch die Bezugsspannung oder Referenzphase, im vorliegenden Fall die Phase L2, vorliegt. Fällt die Referenzphase aus, z.B. durch eine Leiterunterbrechung, so ergibt sich eine Spannungsvektorveränderung entsprechend Figur 3. Die beiden verketteten Spannungen UL2/L3 und UL2/L1 fallen dabei in eine Ebene zusammen. Die Längen ihrer Spannungsvektoren verkürzen sich hierbei um circa die Hälfte.

Um diesen Ausfall zu erfassen, ist vorliegend vorgesehen, dass der Phasenwinkel α zwischen den beiden Spannungen UL2/L3 und UL2/L1 mit einem Winkelmesser oder Winkelmessglied 7 gemessen wird. Der gemessene Winkel α wird in einem nachfolgenden Grenzwertglied 9 auf das Überschreiten eines vorgebbaren Grenzwertes αG überwacht. Gemäss Figur 3 ist leicht erkennbar, dass beim Ausfall der Referenzphase L2 der Winkel α zwischen den beiden verketteten Spannungen UL2/L3 und UL2/L1 1 schlagartig von in der Regel 60° auf etwa 180°( bei umgekehrter Drehrichtung von 300° auf 180°) anwächst. Im Grenzwertglied 9 wird dann zum Beispiel ein Grenzwinkel αG in der Grössenordnung von 120° (bzw. 240°) eingestellt sein. Unter Berücksichtigung der Drehrichtung kann es auch sinnvoll sein, ein Grenzwertband, z.B. zwischen 120° und 240°, vorzusehen.

Wird ein Phasenwinkel a erkannt, der in einem nicht zulässigen Bereich liegt, so wird ein Fehlersignal erzeugt, das gegebenenfalls über einen Indikator 11, z.B. eine Lampe oder ein LCD-Element als Meldeglied angezeigt werden kann. Selbstverständlich sind auch weitere Signalisiermittel oder sich anschliessende Verfahrensweisen zur Verarbeitung der Fehlermeldung denkbar. Dazu ist das Fehlersignal über eine Leitung oder eine nicht näher gezeigte Schnittstelle ausgebbar. Siehe hierzu auch Figur 2 mit der Schnittstelle 23.

In Figur 2 ist für die Darstellung einer alternativen Ausführungsform ein Blockschaltbild eines Elektrizitätszählers 1b in vereinfachter Ausführung gezeigt. Bei diesem elektronischen Gerät ist eine digitale Signalverarbeitung vorgesehen. Nach der Erfassung der verketteten Spannungen UL2/L3 und UL2/L1 werden diese in einem A/D-Wandler 13 digitalisiert und einem Rechner 15 zugeführt. Da für die Ermittlung der von einer Last verbrauchten Energie auch Ströme in den Phasen erforderlich sind, werden diese ebenfalls über entsprechende nicht näher dargestellte Sensoren dem Elektrizitätszählerlb zugeführt. Bei Verwendung der Aronschaltung wird der Strom I2 nicht benötigt. Dieser ist daher strichliert gezeichnet. Über einen weiteren A/D-Wandler 19 gelangen die erfassten und digitalisierten Ströme I1, I3 und ggf. I2 ebenfalls zum Rechner 15. Selbstverständlich können den A/D-Wandlern 13 und 19 noch Anpassmittel, zum Beispiel Widerstände und Filter zur Messsignalanpassung vorgeschaltet sein. Alle hier beschriebenen Ausführungen eignen sich auch für eine Messwerterfassung in Verbindung mit einem oder mehreren Hallelementen, insbesondere bei Ausführung der Aronschaltung.

Im Rechner 15 kann bei Bedarf mit Hilfe eines Programms die fehlende verkettete Spannung UL3/L1 1 rechnerisch nach der bereits oben beschriebenen Weise ermittelt werden. Auf Basis der zur Verfügung stehenden verketteten Spannung UL2/L3, UL2/L1 und UL3/L1 und der Ströme I1, I2 und I3 der Phasen ( bei Aronschaltung mit nur zwei Strömen und zwei Spannungen) kann dann der Energieverbrauch einer im Netz angeordneten Last nach den allgemein bekannten Methoden und Formeln berechnet werden. Der Energieverbrauch kann dann beispielsweise über das Anzeigemodul 21 angezeigt und/oder über die Schnittstelle 23 ausgegeben werden. Selbstverständlich sind auch sonstige nach dem Stand der Technik bekannte Schnittstellen und weitere Verarbeitungseinrichtungen innerhalb des Elektrizitätszählers 1b realisierbar. Der Rechner 15 steuert im vorliegenden Fall - gegebenenfalls auch indirekt - einen Indikator 11 zur Anzeige des Referenzspannungs-Ausfalls an. Gegebenenfalls kann auch innerhalb des Anzeigemoduls 21 eine Signalmöglichkeit vorgesehen werden.

Wesentlich für dieses Ausführungsbeispiel ist ebenfalls, dass die oben beschriebene Funktion der Referenzspannungs-Überwachung durch die Messung eines Phasenwinkels zwischen zwei verketteten Spannungen erfolgt. Die Verfahrensschritte mit dem Winkelmessglied 7 und dem Grenzwertglied 9 werden dann als Programmbausteine oder -schritte im Rechner 15 ausgeführt. Vorteilhaft ist die Funktion der Referenzspannungs-Überwachung in Verbindung mit der Aronschaltung einsetzbar, die dann ebenfalls rechentechnisch im Rechner 15 mit einem Programm realisiert wird. Selbstverständlich verfügt der Rechner 15 über übliche, für seinen Betrieb nötige Hilfseinrichtungen, beispielsweise einen nicht näher gezeigten Speicher für die Ablage von Werten und Daten und der Speicherung von Programmen.

Diese Ausführungsvariante ist insbesondere bei der Ausführung als digitaler Elektrizitätszähler zweckmässig, da bei digitalen Zählern ohnehin zur Ermittlung der Drehfeldrichtung gegebenenfalls eine Winkelmessung als Software-Programm vorgesehen sein kann. Dieses Programm-Modul kann dann bevorzugt für die zu lösende Aufgabe zum Einsatz kommen. Die Referenzspannungs-Überwachung kann vorteilhaft auch als indirekter Strom-Diebstahl-Indikator verwendet werden (Anti-tampering). Bei einer Ausführungen als digitaler Zähler sind auch unterschiedliche Aufteilungen der A/D-Wandler oder auch zusätzliche Prozessoren im Rahmen der allgemein bekannten digitalen Signaltechnik möglich.

## Patentansprüche

1. Verfahren zur Phasenausfall-Überwachung in einem elektronischen Gerät (1a, 1b), insbesondere einem Elektrizitätszähler (1a, 1b), für Drehspannung mit folgenden Schritten:
- Es werden zwei verkettete Spannungen (UL2/L3, UL2/L1) eines Dreiphasen-Drehstromnetzes erfasst,
- es wird der Phasenwinkel (α) zwischen den zwei erfassten verketteten Spannungen (UL2/L3, UL2/L1) ermittelt und mit einem vorgegebenen Grenzwinkel (αG) verglichen,
- im Falle einer Überschreitung des vorgegebenen Grenzwinkels (αG) durch den ermittelten Phasenwinkel (α) wird ein Fehlersignal für den Ausfall der gemeinsamen Bezugsphase zwischen den zwei erfassten Spannungen (UL2/L3, UL2/L1) erzeugt.

2. Verfahren nach Anspruch 1, wobei die zwei erfassten verketteten Spannungen (UL2/L3, UL2/L1) vor der weiteren Verarbeitung digitalisiert werden.

3. Verfahren nach Anspruch 1 oder 2, wobei mittels Addition oder Summation der zwei erfassten verketteten Spannungen (UL2/L3, UL2/L1) die dritte verkettete Spannung (UL3/L1) nachgebildet wird.

4. Verfahren nach Anspruch 1 oder 2, wobei die drei Phasen des Drehstromnetzes mit einer Aronschaltung verbunden sind, mittels derer ein Energieverbrauch einer an das Drehstromnetz angeschlossenen Last ermittelt wird.

5. Verfahren nach Anspruch 3, wobei zwei oder alle verketteten Spannungen (UL2/L3, UL2/L1, UL3/L1) zur Ermittlung eines Energieverbrauchs einer Last am Drehstromnetz verwendet werden.

6. Elektronisches Gerät (1a, 1b), insbesondere Elektrizitätszähler (1b), für Drehspannung mit:
- Zwei Spannungssensoren (4) zur Erfassung von zwei verketteten Spannungen (UL2/L3, UL2/L1) eines Dreiphasen-Drehstromnetzes, einem Winkelmesser (7) mit einem Grenzwertglied (9) und einem Meldeglied (11),
wobei dem Winkelmesser (7) die zwei erfassten verketteten Spannungen (UL2/L3, UL2/L1) zugeführt sind und im Falle einer Überschreitung eines vorgegebenen Grenzwertes (αG) durch den zwischen den erfassten verketteten Spannungen (UL2/L3, UL2/L1) gemessenen Phasenwinkel (α) mit dem Meldeglied (11) ein Signal für den Ausfall der gemeinsamen Bezugsphase (L2) zwischen den zwei erfassten Spannungen (UL2/L3, UL2/L1) erzeugt ist.
